Europäisches Patentamt

European Patent Office

Office européen des brevets

(11) Veröffentlichungsnummer: **0 058 852**
**B1**

(12) **EUROPÄISCHE PATENTSCHRIFT**

(45) Veröffentlichungstag der Patentschrift:
**03.06.87**

(21) Anmeldenummer: **82100766.3**

(22) Anmeldetag: **03.02.82**

(51) Int. Cl.⁴: **H 01 L 23/48**

(54) **Halbleiteranordnung mit aus Blech ausgeschnittenen Anschlussleitern.**

(30) Priorität: **20.02.81 DE 3106376**

(43) Veröffentlichungstag der Anmeldung:
**01.09.82 Patentblatt 82/35**

(45) Bekanntmachung des Hinweises auf die Patenterteilung:
**03.06.87 Patentblatt 87/23**

(84) Benannte Vertragsstaaten:
**DE FR GB IT**

(56) Entgegenhaltungen:
**DE - A - 1 800 347**
**US - A - 3 476 990**
**US - A - 3 707 655**
**US - A - 4 067 040**

(73) Patentinhaber: **Siemens Aktiengesellschaft Berlin und München, Wittelsbacherplatz 2, D-8000 München 2 (DE)**

(72) Erfinder: **Wurz, Erwin, Ing.grad., Hoflacherstrasse 53, D-8031 Eichenau (DE)**

### Beschreibung

Die Erfindung bezieht sich auf eine Halbleiteranordnung mit aus Blech ausgeschnittenen, Hauptflächen aufweisenden Anschlussleitern mit Kontaktflächen für die Befestigung je eines Bonddrahtes vorgesehenen Stützpunkten und mit fluchtend hintereinander angeordneten Bonddrähten, die einerseits an einem auf einer der Kontaktflächen sitzenden Halbleiterkörper und andererseits an einem Stützpunkt befestigt sind.

Eine solche Anordnung ist beispielsweise in der DE-A-1 800 347 beschrieben worden. Das dort beschriebene Ausführungsbeispiel hat drei nebeneinander angeordnete Anschlussleiter. Auf dem mittleren Anschlussleiter sitzt ein Halbleiterkörper, der mit je einem Bonddraht mit einem Stützpunkt auf dem linken und rechten Anschlussleiter elektrisch verbunden ist. Beide Bonddrähte liegen fluchtend hintereinander. Durch diese Anordnung wird erreicht, dass der Bonder oder die Halbleitervorrichtung beim Bonden keine Seitwärtsbewegung vornehmen muss. Bei der beschriebenen Anordnung folgt auf eine Bondverbindung am ersten Stützpunkt eine Bondverbindung am Halbleiterkörper, dann eine Bondverbindung am Halbleiterkörper und eine Bondverbindung am zweiten Stützpunkt. Da ein Bonder jedoch nur entweder von einem Stützpunkt zum Halbleiterkörper oder nur umgekehrt bonden kann, bedeutet die bekannte Anordnung, dass der Bonder seine Bewegungsrichtung in jeder Halbleiteranordnung einmal umkehren muss.

Die Erfindung bezweckt eine Verbesserung einer solchen Anordnung derart, dass eine Umkehr der Bewegungsrichtung des Bonders überflüssig wird.

Dies wird dadurch erreicht, dass zwei in Richtung der Bonddrähte hintereinanderliegende Halbleiterkörper vorgesehen sind, und dass die Halbleiterkörper und Stützpunkte derart angeordnet sind, dass auf eine Bondverbindung am Stützpunkt jeweils eine Bondverbindung am Halbleiterkörper folgt.

Eine Weiterbildung der Erfindung ist Gegenstand des Unteranspruchs.

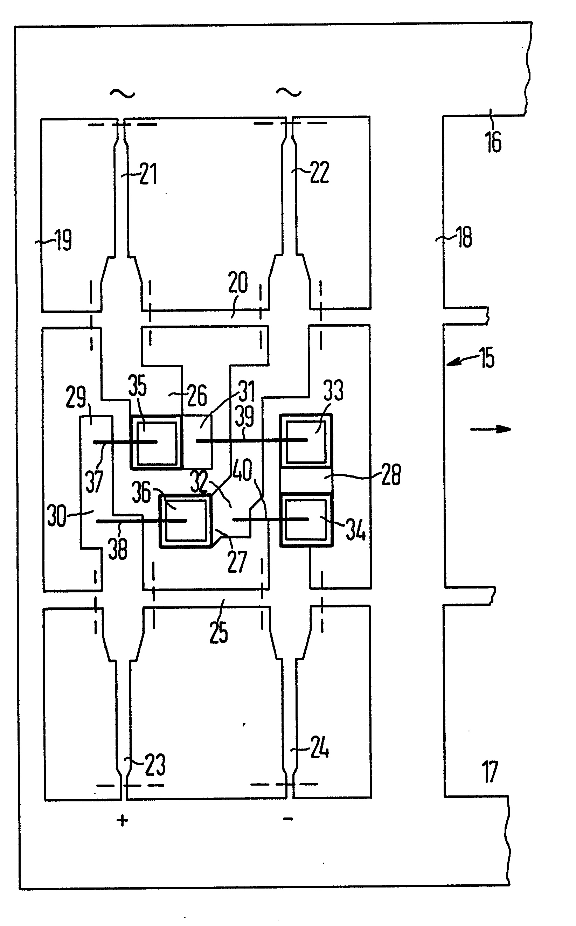

Die Erfindung wird anhand eines Ausführungsbeispiels in Verbindung mit der einzigen Figur näher erläutert. Die Figur zeigt eine Aufsicht auf eine ungekapselte Halbleiteranordnung.

In der Figur ist eine Vollweg-Gleichrichterbrücke dargestellt. Diese weist ein aus Blech ausgeschnittenes Leitersystem 15 auf, das zwei Längsstege 16, 17 und zwei Querstege 18, 19 sowie zwei Dichtstege 20, 25 enthält. Die Brücke hat vier Anschlussleiter 21, 22, 23 und 24, die mit den Längsstegen 16 bzw. 17 in Verbindung stehen. Das Leitersystem weist Hauptflächen auf, von denen sich eine dem Betrachter darbietet und Schnittflächen, die senkrecht zu den Hauptflächen liegen. Der Anschlussleiter 21 hat an seinem einen Ende eine Kontaktfläche 26, auf der ein Halbleiterkörper 35 sitzt. Er weist ausserdem einen Stützpunkt 31 zur Anbringung eines Bonddrahts 39 auf. Der Anschlussleiter 22 trägt eine Kontaktfläche 27, auf der ein Halbleiterkörper 36 sitzt sowie einen Stützpunkt 32 für einen Bonddraht 40. Der Anschlussleiter 23 hat zwei Stützpunkte 29, 30 für zwei Bonddrähte 37, 38. Der Anschlussleiter 24 weist eine Kontaktfläche 28 auf, die für die Aufnahme von zwei Halbleiterkörper 33 und 34 bestimmt ist. Die Halbleiterkörper sind in zwei nebeneinanderliegenden Gruppen hintereinanderliegend angeordnet. Dies ist jedoch nicht zwingend, für bestimmte Zwecke, z.B. für eine Mittelpunktschaltung kann es auch ausreichend sein, wenn nur zwei hintereinander liegende Halbleiterkörper vorgesehen sind.

Die zu den Halbleiterkörpern 35 und 33 gehörenden Kontaktflächen und ihre Stützpunkte liegen in Vorschubrichtung (Pfeilrichtung) gesehen hintereinander. Damit können die Bonddrähte 37 und 39 fluchtend hintereinander angeordnet werden. Ausserdem folgt auf eine Bondverbindung am Stützpunkt immer eine Bondverbindung am Halbleiterkörper, so dass der Bonder nur in einer Richtung bewegt werden muss. Dies führt zu einer erheblichen Beschleunigung des Bondens. Gleiches gilt auch für die Halbleiterkörper 34 und 36 und die ihnen zugeordneten Stützpunkte 32, 30.

Die Kontaktflächen und Stützpunkte sind von den Hauptflächen des Leitersystems 15 gesehen ein- oder mehrfach gekröpft. Dies empfiehlt sich zur optimalen Ausnutzung des Raumes, wenn ein fester Abstand zwischen den Anschlussleitern 21 und 22 bzw. 23 und 24 vorgeschrieben ist. Ist der genannte Abstand frei wählbar, so können die Stützpunkte und Kontaktflächen als gerade Streifen ausgebildet werden.

Die Halbleiterkörper können mit ihren Kontaktflächen auf den Anschlussleitern verlötet oder verklebt sein. Damit sind sie mechanisch gehaltert und elektrisch kontaktiert.

Nach dem Verbinden der Halbleiterkörper mit den Anschlussleitern wird die Halbleiteranordnung z.B. mit Kunststoff umpresst. Anschliessend werden die Anschlussleiter und die Dichtstege an den gestrichelten Stellen abgetrennt.

### Patentansprüche

1. Halbleiteranordnung mit aus Blech ausgeschnittenen, Hauptflächen aufweisenden Anschlussleitern mit Kontaktflächen und für die Befestigung je eines Bonddrahtes vorgesehenen Stützpunkten und mit fluchtend hintereinander angeordneten Bonddrähten, die einerseits an einem auf einer der Kontaktflächen sitzenden Halbleiterkörper und andererseits an einem Stützpunkt befestigt sind, dadurch gekennzeichnet, dass zwei in Richtung der Bonddrähte (37, 38, 39, 40) hintereinanderliegende Halbleiterkörper (33, 34, 35, 36) vorgesehen sind, und dass die Halbleiterkörper und Stützpunkte (29, 30, 31, 32) derart angeordnet sind, dass auf eine Bondverbindung am Stützpunkt jeweils eine Bondverbindung am Halbleiterkörper folgt.

2. Halbleiteranordnung nach Anspruch 1, dadurch gekennzeichnet, dass zwei nebeneinanderliegende Gruppen von hintereinanderliegenden Halbleiterkörpern (33, 35, 34, 36) vorgesehen sind und dass die Bonddrähte (37, 38, 39, 40) der genannten Gruppen einander parallel liegen.

## Claims

1. A semiconductor arrangement having terminal conductors which are cut out from sheet metal, and are provided with main surfaces, contact surfaces, and support points for the attachment in each case of a bonding wire, and having bonding wires which are arranged in serial alignment and which are attached, on one side, to a semiconductor body located on one of the contact surfaces and on the other side to a support point, characterised in that two semiconductor bodies (33, 34, 35, 36) are provided which are arranged in series in the direction of the bonding wires (37, 38, 39, 40); and that the semiconductor bodies and support points (29, 30, 31, 32) are arranged in such manner that a bonded connection to the support point is in each case followed by a bonded connection to the semiconductor body.

2. A semiconductor arrangement as claimed in Claim 1, characterised in that two juxtaposed groups of series-arranged semiconductor bodies (33, 35, 34, 36) are provided; and that the bonding wires (37, 38, 39, 40) of the aforesaid groups are arranged parallel to one another.

## Revendications

1. Dispositif à semiconducteurs comportant des conducteurs de raccordement qui sont découpés dans une tôle, possèdent des surfaces principales et portent des surfaces de contact et des points de soutien prévus pour la fixation d'un fil de liaison respectif, et des fils de liaison disposés les uns derrière les autres en étant alignés et qui sont fixés d'une part sur un corps semiconducteur disposé sur l'une des surfaces de contact et d'autre part en un point de soutien, caractérisé par le fait qu'il est prévu deux corps semiconducteurs (33, 34, 35, 36) qui sont situés l'un derrière l'autre dans la direction des fils de liaison (37, 38, 39, 40) et que les corps semiconducteurs et les points de soutien (29, 30, 31, 32) sont disposés de telle sorte qu'une liaison sur le corps semiconducteur succède respectivement à une liaison sur le point de soutien.

2. Dispositif à semiconducteurs suivant la revendication 1, caractérisé par le fait qu'il est prévu deux groupes, situés l'un derrière l'autre, de corps semiconducteurs (33, 35, 34, 36) situés les uns derrière les autres et que les fils de liaison (37, 38, 39, 40) desdits groupes sont parallèles entre eux.